# EUROPEAN PATENT APPLICATION

(11) **EP 1 734 586 A1**
(43) Date of publication of application: **20.12.2006**
(21) Application number: 05720003.2
(22) Date of filing: 04.03.2005
(51) Int. Cl.: H01L 29/78, C23C 16/42, H01L 21/316, H01L 21/336

(54) **METHOD FOR MANUFACTURING SEMICONDUCTOR DEVICE**

(30) Priority: 09.04.2004 JP 2004115470
(71) Applicant: FUJI ELECTRIC HOLDINGS CO., LTD., Kawasaki-shi, Kanagawa 210-0856 (JP)
(72) Inventor: OGINO, M.; c/o FUJI ELECTRIC ADVANCED TEC. CO LTD, Kanagawa 2400194 (JP); SUGAHARA, Y.; c/o FUJI ELECTRIC ADVANCED TEC. CO, Kanagawa 2400194 (JP)
(74) Representative: Appelt, Christian W.
(86) International application number: PCT/JP2005/003731
(87) International publication number: WO 2005/101518

(57) **Abstract**

There is provided a semiconductor device having a high breakdown voltage and a high reliability in which a gate insulating film having a film thickness of good uniformity is formed inside a trench. An HTO is formed on an inner wall of a trench in an Si substrate by a reduced pressure CVD method and, thereafter, a thermally oxidized film is formed on an interface between the HTO and the Si substrate by performing a thermal oxidation treatment (Samples A and C). By performing these procedures as described above, the gate insulating film in which local thinning of the film is suppressed, film thickness is of good uniformity and an interface state density is low can be formed inside the trench. A semiconductor device, which has a trench gate structure, of a high quality and a high reliability having no reduction in the breakdown voltage in which a lifetime comes to be substantially longer compared with that (Sample B) in which the gate insulating film is formed only with a thermally oxidized film can be realized.

## Description

### Technical Field

The present invention relates to a method for manufacturing a semiconductor device and, more particularly, to a method for manufacturing a semiconductor device having a trench gate structure in which a current path is formed along a trench of a semiconductor substrate.

### Background Art

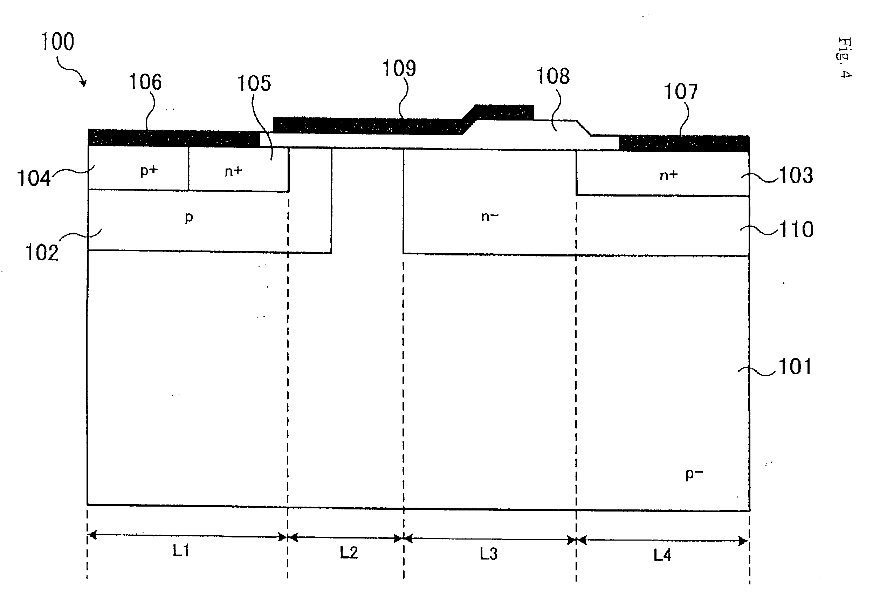

FIG. 4 is an example of a cross-sectional diagram of a semiconductor device having a planar gate structure.
The semiconductor device shown in FIG. 4 is a so-called lateral MISFET (Metal Insulator Semiconductor Field Effect Transistor). In this MISFET 100, a p type base region 102 and an n⁺type drain region 103 are formed on a surface layer of a p⁻type semiconductor substrate 101, and a source electrode 106 is formed on a p⁺type source region 104 formed inside the p type base region 102 and an n⁺type source region 105, while a drain electrode 107 is formed on the n⁺type drain region 103. A gate insulating film 108 is formed between the source electrode 106 and the drain electrode 107 and, on the thus-formed gate insulating film 108, a gate electrode 109 is formed.

In this MISFET 100, an n⁻type extended drain 110 is formed between the p type base region 102 and the n⁺type drain region 103. An electric field between the n⁺type source region 105 and the n⁺type drain region 103 is relaxed by this n⁻type extended drain 110, to thereby try to realize a higher breakdown voltage.

The MISFET 100 mainly contains a source region (region length L1), a channel region (region length L2), an extended drain region (region length L3) and a drain region (region length L4), and a device pitch is determined in accordance with a sum (L1+L2+L3+L4) of each region length. As the device pitch comes to be smaller, a degree of integration of the device comes to be larger and, further, an on-resistance thereof comes to be smaller.

However, when realization of the higher breakdown voltage of the device is aimed for, a contribution of the extended drain region to the breakdown voltage is large. As the region length L3 thereof comes to be larger, the breakdown voltage comes to be higher and, therefore, when the higher breakdown voltage is realized, the device pitch is increased, namely, there is a trade-off relation between the degree of the integration and the breakdown voltage.

Then, recently, a TLPM (Trench Lateral Power MISFET) in which the extended drain region is formed in a trench portion of the semiconductor substrate and improvement of the degree of integration and improvement of the breakdown voltage are simultaneously realized is proposed.

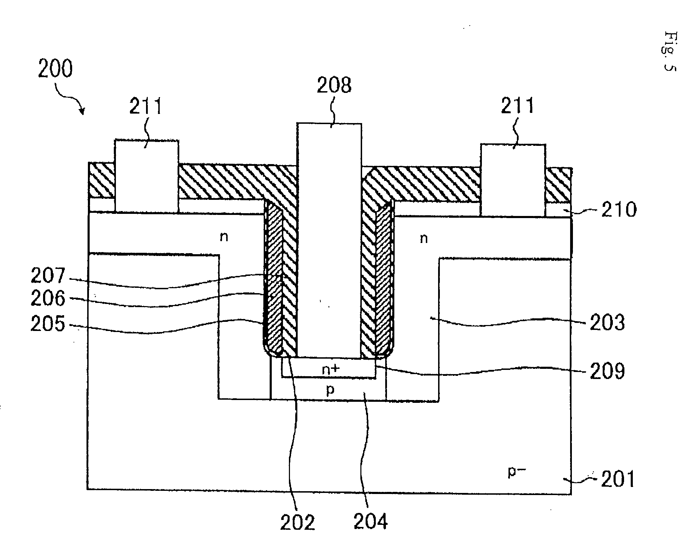

FIG. 5 is a partial cross-sectional diagram of an example of a TLPM.
A trench 202 is formed on a p⁻type semiconductor substrate 201 of a TLPM 200 shown in FIG. 5 and, on a side of the trench 202, an n type extended drain 203 is formed and, on a lower side thereof, a p type base region 204 is formed. Further, in the trench 202, a gate insulating film 205 is formed on a side wall thereof and, inside the gate insulating film 205, a gate electrode 206 containing polysilicon is formed-. -In the trench 202, further inside the gate electrode 206, a first insulating film 207 is formed, and a source electrode 208 is formed via this first insulating film 207. The source electrode 208 is connected with an n⁺type source region 209 formed inside the p type base region 204 in a bottom portion of the trench 202.

A second insulating film 210 is formed on a surface of the p⁻type semiconductor substrate 201 except a trench portion, and the first insulating film 207 which is formed in the trench portion extends to over the second insulating film 210. A drain electrode 211 is connected with the n type extended drain 203 passing through the first and second insulating films 207, 210

By forming such trench gate structure as described above, it becomes possible to try to reduce the device pitch while forming a current path in the trench portion and, then, to realize a higher integration density and a higher breakdown voltage.

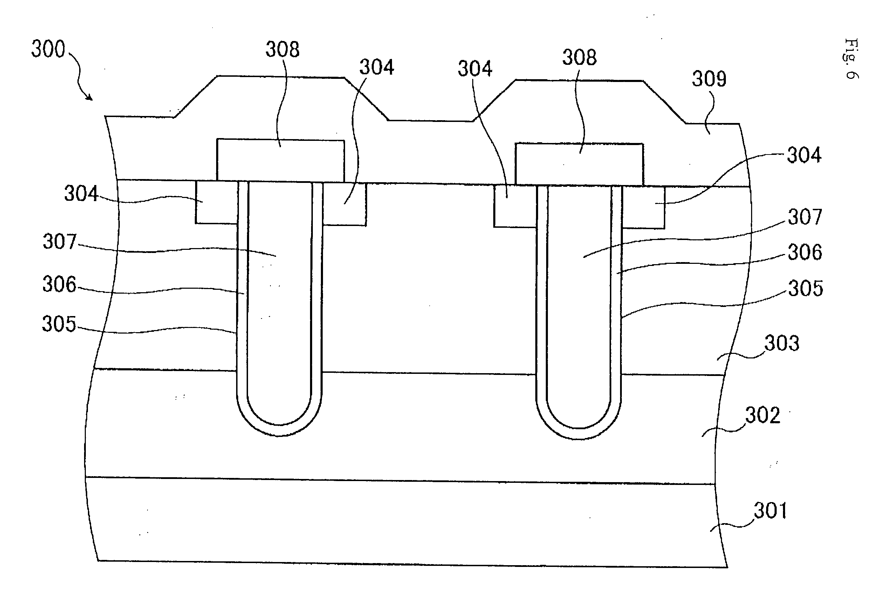

FIG. 6 is a partial cross-sectional diagram of another example of a semiconductor device having a trench gate structure.
AMISFET 300 shown in FIG. 6 contains an electric field relaxation region 302 formed on a semiconductor substrate 301 by an epitaxial method or the like, a conductivity type base region 303 opposite of the electric field relaxation region 302, and a conductivity type source region 304 same as the electric field relaxation region 302. A gate electrode 307 is formed via a gate insulating film 306 inside a trench 305 which is formed such that it passes through the source region 304 and the base region 303 and reaches an inside of the electric field relaxation region 302. An interlayer insulating film 308 is formed on an upper portion of the gate electrode 307 and, further, on an upper portion of the thus-formed insulating film 308, a source electrode 309 which is in contact with the source region 304 is formed such that it covers an entire body.

Also in a case of such trench gate structure as described above, in a similar manner as described above, when the transistor comes in an on-state, a current path is formed along a side wall of the trench 305 in a vertical direction seen in FIG. 6. For this account, even when width of the gate electrode 307, namely, the trench 305 is narrowed, a channel length can be maintained and, then, it comes to be possible to realize the improvement of the degree of integration and the improvement of the breakdown voltage.

Meanwhile, the gate insulating film of each of various types of semiconductor devices inclusive of the MISFET having the above-described structure is mainly formed by a thermal oxidation method or a Chemical Vapor Deposition (CVD) method. Conventionally, as for the formation of the gate insulating film, in addition to a method in which the thermal oxidation method or the CVD method is performed, a method in which a combination of the thermal oxidation method and the CVD method is performed or the like is proposed.

With reference to the method in which such combination as described above is performed, for example, as for production of a planar type semiconductor device, there is proposed a method in which a gate insulating film is constituted on a substrate such that a thermal oxidation film is formed between a semiconductor substrate and a CVD film by either performing the CVD after performing the thermal oxidation or performing the thermal oxidation after performing the CVD (for example, refer to Patent Documents 1 and 2). Further, as for production of a trench type semiconductor device, there is proposed a method in which a gate insulating film is formed inside a trench by firstly forming the trench in a semiconductor substrate, next performing the CVD after performing the thermal oxidation and, then, performing an annealing treatment (refer to Patent Document 3).
Patent Document 1: JP-A-62-216370 (page 2, FIG. 1);
Patent Document 2: JP-A-6-140627 (paragraphs [0012] to [0013], and [0018], FIG. 3); and
Patent Document 3: JP-A-2001-85686 (paragraphs [0010] to [0011], FIG. 1).

### Disclosure of the Invention

### Problems that the Invention is to Solve

A trench gate structure is capable of simultaneously realizing a higher integration density and a high breakdown voltage which are in a trade-off relation in a planar gate structure. However, a trench is formed by etching a semiconductor substrate and various plane directions of the semiconductor substrate appear on an inner wall thereof. For this account, when a gate insulating film is formed by thermal oxidation, a thick portion and a thin portion are inevitably generated in the oxide film thereof in accordance with the various plane directions. Particularly, even when a high-temperature oxidation is performed which will generate a viscous flow of the oxide film, the oxide film at a corner portion in an upper portion of the trench comes to be thin to some extent by an action of stress brought about by a volume expansion by oxidation and a three-dimensional structure. Further, such thinning of the oxide film as described above occurs not only on the upper portion of the trench but also on a bottom portion of the trench.

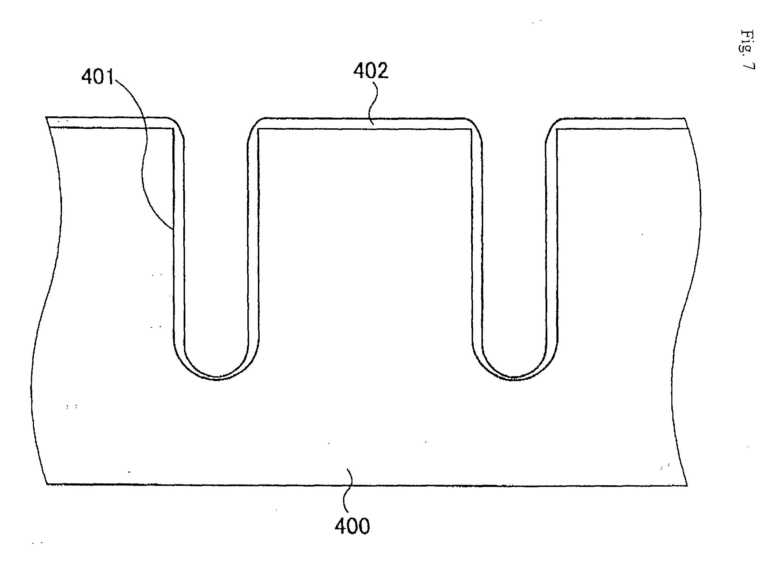

FIG. 7 is a schematic cross-sectional diagram of an example of a thermally-oxidized state of a semiconductor substrate which has been subjected to trench formation.
As shown in FIG. 7, when a semiconductor substrate 400 is thermally oxidized, a thermally oxidized film 402 is formed on a surface of the semiconductor substrate 400 and an inner wall of a trench 401 formed therein. However, as described above, thinning of the thermally oxidized film 402 tends to occur in an upper portion or a bottom portion of the trench 401. Further, even when the bottom portion of the trench 401 is formed in a round shape as shown in FIG. 7, as width of the trench 401 is shrunk more for aiming at reduction in a device pitch, a curvature of the bottom portion thereof comes to be larger; therefore, this state comes to be more conspicuous.

In the semiconductor device having a portion in which the oxide film is thin, there may occur a problem in that, at the time of operation, electric field tends to be concentrated on the portion and, as a result, the breakdown voltage is reduced.
Further, it may be considered to try to attain a film thickness of good uniformity by forming a CVD film on the thermally oxidized film having such irregularity as described above within the range of a given value of a total film thickness of the gate insulating film, but there still is a case in which sufficient uniformity can not be attained and, in a same manner, such concentration of the electric field and reduction in the breakdown voltage may occur.

Further, when thermal oxidation is performed, there is a case in which strain or dislocation by remaining stress to be caused by a volume expansion at that time is generated in the oxide film, to thereby sometimes cause the concentration of the electric field or reduction in the breakdown voltage.
Further, as for a factor for reducing reliability of the gate insulating film, contamination with a heavy metal at the time of trench etching may be mentioned. Ordinarily, after the trench etching, for the purpose of removing an etching damage or removing a heavy metal such as iron, aluminum, or nickel which is capable of being infiltrated in the semiconductor substrate at the time of etching, a sacrificial oxide film is formed or an inner wall of the trench is scraped off by isotropic dry etching. However, when reduction in the device pitch is progressed and, then, width of the trench is shrunk, it comes necessary to suppress an amount of sacrificial oxidation or to allow film thickness to be removed by the isotropic dry etching to be smaller and, therefore, removal of the etching damage or removal of the heavy metal can not sufficiently be performed.

In view of these problems, the invention has been achieved and has an object to provide a method for producing a semiconductor device having a trench gate structure in which a gate insulating film having a film thickness of good uniformity and high reliability is formed in a trench.

### Means for Solving the Problems

In order to solve these problems, in the invention, there is provided a method for producing a semiconductor device, which has a trench gate structure, being characterized by having the steps of:
forming an oxide film by a CVD method on an inner wall of a trench formed in a semiconductor substrate;
forming a thermally oxidized film on an interface between the oxide film and the semiconductor substrate by a thermal oxidation method; and
forming a gate insulating film containing the oxide film and the thermally oxidized film in the trench.

According to the method for producing the semiconductor device, firstly, an oxide film is formed with good uniformity on an inner wall of a trench of a semiconductor substrate by a CVD method such as a reduced pressure CVD method having good-coverage characteristics and, then, a thermal oxidation treatment is performed by, for example, a pyrogenic oxidation method and, thereafter, oxygen is supplied to a surface of the semiconductor substrate via the oxide film formed by the CVD method, to thereby form a thermally oxidized film on an interface thereof. By such procedures as described above, an excellent gate insulating film which is not locally thinned and has a film thickness of good uniformity can be formed in the trench. Besides, by forming the thermally oxidized film on an interface between the oxide film by the CVD method and the semiconductor substrate, a stable interface having a low interface state density can be obtained.

Further, according to the invention, there is provided a method for producing a semiconductor device, which has a trench gate structure, being characterized by having the step of:
forming an oxide film on an inner wall of a trench formed in a semiconductor substrate by a CVD method using a gas containing dichlorosilane and dinitrogen monoxide as a raw material.

According to the method for producing the semiconductor device, when dichlorosilane and dinitrogen monoxide are used as raw materials at the time of forming the oxide film on the inner wall of the trench by the CVD method, it becomes easy to remove a heavy metal even when it is infiltrated in the semiconductor substrate at the time of trench etching by a gettering effect of chlorine in dichlorosilane

### Advantage of the Invention

In the method for producing the semiconductor device according to the invention, at the time of forming the gate insulating film on the inner wall of the trench of the semiconductor device, firstly, the oxide film is formed by the CVD method and, then, the thermally oxidized film is formed between the oxide film and the semiconductor substrate by the thermal oxidation method. By these arrangements, local thinning of the gate insulating film to be formed in the trench is suppressed and the gate insulating film with high quality having no reduction in breakdown voltage and having a low interface state density can be formed. Since contamination of a heavy metal is suppressed therein, reliability thereof can be enhanced. Further, on this occasion, the semiconductor device having a trench gate structure of high quality and high reliability can be realized.

The above and other objects, features and advantages of the present invention will become more apparent from the following description of embodiments thereof taken in conjunction with the accompanying drawings.

### Brief Description of the Drawings

FIG. 1 is an evaluation result of a constant current TDDB property of a trench gate sample;
FIG. 2 is an evaluation result of a constant current TDDB property of a planar gate sample;
FIG. 3 is a schematic cross-sectional diagram of a gate insulating film;
FIG. 4 is an example of a cross-sectional diagram of a semiconductor device having a planar gate structure;
FIG. 5 is a partial cross-sectional diagram of an example of a TLPM;
FIG. 6 is a partial cross-sectional diagram of another example of a semiconductor device having a trench gate structure; and
FIG. 7 is a schematic cross-sectional diagram of an example of a thermally-oxidized state of a semiconductor substrate which has been subjected to trench formation.

### Best Mode for Carrying Out the Invention

Hereinafter, the present invention will be described in detail with reference to the accompanied drawings which illustrate the preferred embodiments of the invention.
First of all, a method of forming an MOS capacitor having the trench gate structure used for evaluation of reliability of the gate insulating film is described.

In forming the MOS capacitor, firstly, a trench is formed on an Si substrate by etching and, after sacrificial oxidation is performed in order to remove an etching damage remaining on the Si substrate (trench surface), Local Oxidation of Silicon (LOCOS) is formed. On this occasion, the trench is allowed to have, for example, a width of 2.6 µm and a depth of 2 µm.

Next, a High Temperature Oxide (HTO) is formed by using dichlorosilane (SiH₂Cl₂) and dinitrogen monoxide (N₂O) as raw material gases by a reduced pressure CVD method such that it has a thickness of 13 nm. On this occasion, formation conditions are set such that, for example, flow rates of dichlorosilane and dinitrogen monoxide are set to be 150 ml/min (0°C, 101.3 kPa) and 75 ml/min (0°C, 101.3 kPa), respectively (hereinafter, unit of flow under these conditions is referred to also as "sccm"), a film-forming temperature is 800°C and a pressure is 60 Pa.

A ratio of the flow rate of dichlorosilane to that of dinitrogen monoxide can be varied in a wide range of from about 1:5 to about 1:0.3 and, ordinarily, as the ratio of the flow rate of dichlorosilane to that of dinitrogen monoxide becomes larger, a film-forming speed becomes larger. For this account, for example, the film thickness of the gate insulating film to be finally formed (referred to also as "final film thickness") is as large as 100 nm and, when it is necessary to form the HTO having a large film thickness, so long as the ratio of the flow rate of dichlorosilane to that of dinitrogen monoxide is allowed to be 1:0.3, a thick HTO can efficiently be formed.

On this occasion, firstly, the HTO is formed in the trench such that it has a film thickness of 13 nm and, then, a thermal oxidation treatment is performed to form the gate insulating film with a final film thickness of 17 nm. For this account, the film thickness of the HTO to be formed is relatively small and a ratio of the flow rate of dichlorosilane to that of dinitrogen monoxide is allowed to be 2:1. However, since a film-forming time duration at this time is about 20 minutes, even when a ratio of flow rate of dichlorosilane to that of dinitrogen monoxide is reduced to a small extent, throughput is hardly reduced and, for example, even when the ratio of the flow rate of dichlorosilane to that of dinitrogen monoxide is allowed to be 1:2, there is no problem.

Next, the thermal oxidation treatment is performed in a thermal treatment furnace at a temperature of about 800°C in a pyrogenic atmosphere. By this thermal oxidation treatment, oxidizing species (O₂, H₂O) are diffused in the HTO previously formed, supplied on a surface of the Si substrate and, then, the thermally oxidized film is formed on an interface between the HTO and the Si substrate. At the time of this thermal oxidation treatment, thermal oxidation time duration is adjusted such that the final film thickness of the gate insulating film to be formed with the HTO and the thermally oxidized film comes to be 17 nm. After the thermal oxidation treatment, by continuously using the same thermal treatment furnace, temperature is raised up to about 1000°C in an atmosphere of nitrogen and an annealing treatment is performed at this temperature for 10 minutes. Finally, polysilicon which becomes a gate electrode is formed by a reduced pressure CVD method and, then, the gate electrode is formed by a photolithography technique. Thereafter, for example, an interlayer insulating film is formed and, further, even an Al wiring is formed, to thereby form an MOS capacitor (Sample A). On this occasion, a gate area of the MOS capacitor is 0.25 mm².

Next, an evaluation of a constant current TDDB (Time Dependent Dielectric Breakdown) property of a trench gate sample (Sample A) in which the MOS capacitor having the trench gate structure is formed in this manner is explained.

Further, on this occasion, for the purpose of comparison, a constant current TDDB property test is performed also on each of Sample B in which the thermal oxidation treatment and the annealing treatment are performed on the trench of the Si substrate and, then, the gate insulating film having a final film thickness of 17 nm is formed only with the thermally oxidized film and Sample C in which, after the HTO having a film thickness of 10 nm is formed in the trench by the reduced pressure CVD method, the thermal oxidation treatment and the annealing treatment are performed to form the gate insulating film having a final film thickness of 17 nm. Further, other constitutional factors, film-forming conditions and the like than the gate insulating film are same all through Samples A, B and C.

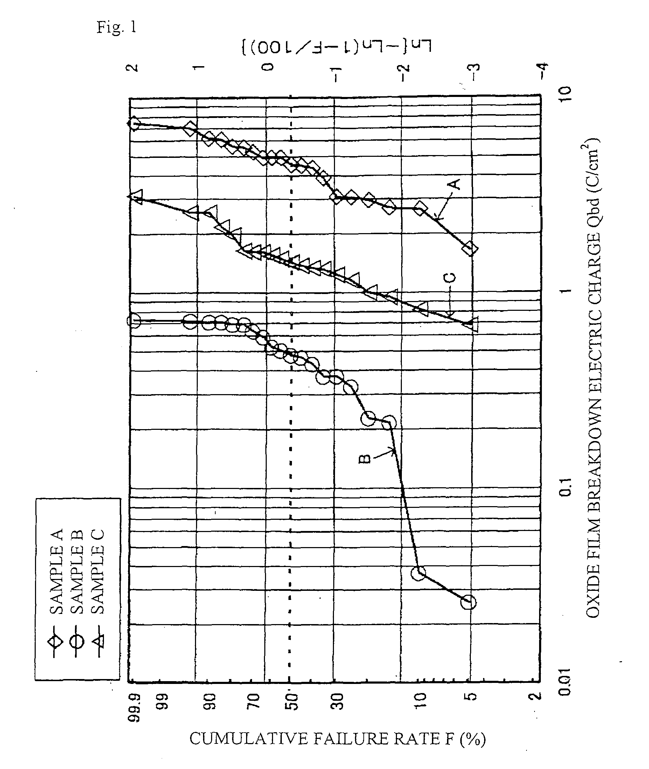

FIG. 1 is an evaluation result of a constant current TDDB property of a trench gate sample.
In FIG. 1, an axis of abscissa and an axis of ordinate show oxide film breakdown electric charge Qbd (C/cm²) and cumulative failure rate F (%), respectively. Further, this constant current TDDB property test is performed using Samples A, B and C each having the trench gate structure in which 20 MOS capacitors are each formed per sheet of wafer under the conditions of a stress current density of 0.1 A/cm² and a gate negative bias.

From FIG. 1, when the oxide film breakdown electric charge Qbd is taken as 50% at the time of the cumulative failure rate F being 50%, 50% Qbd of each of Samples A, B and C is as shown in Table 1.

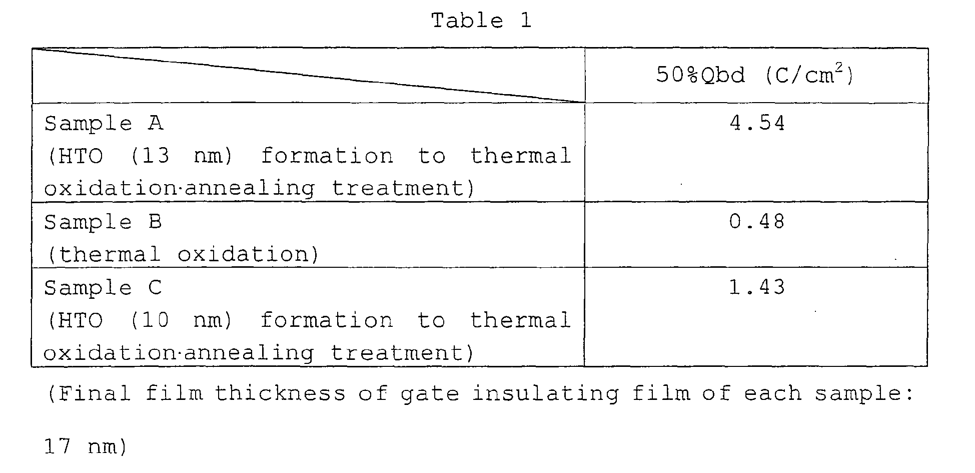

As shown in FIG. 1, 50% Qbd is 4.54 C/cm² in Sample A; 50% Qbd is 0.48 C/cm² in Sample B; and 50% Qbd is 1.43 C/cm² in Sample C. From the result in FIG. 1, in Sample A in which, after the HTO having a film thickness of 13 nm is formed, a gate insulating trim is formed by performing the thermal oxidation treatment and the annealing treatment, the gate insulating film has a lifetime about 10 times longer than that in Sample B which is formed only with the thermally oxidized film.

Further, although, in Sample C in which, after the HTO having a film thickness of 10 nm is formed, the gate insulating film is formed by performing the thermal oxidation treatment and the annealing treatment, the gate insulating film has a lifetime shorter than that in Sample A in which HTO having a flm thickness of 13nm is formed but about three times longer than that in Sample B formed only with the thermally oxidized film.

Next, an influence which difference of the method for producing the oxide film will give to the interface state density (Dit) is described.
In order to measure the interface state density of each of samples of different methods for producing the oxide film, on this occasion, a CV measurement is performed by using a mercury probe on Sample D in which the HTO is formed on a bare Si wafer by using dichlorosiliane and dinitrogen monoxide as raw material gases by a reduced pressure CVD method and on Sample E in which after the HTO of Sample D is formed, the thermally oxidized film is formed on an SiO₂/Si interface by further performing the thermal oxidation treatment and, then, the annealing treatment is performed. Still further, the CV measurement is performed also on Sample F in which after the HTO is formed on the bare Si wafer in a same manner as in the formation of Sample D except for using monosilane in place of dichlorosilane and on Sample G in which after the HTO of Sample F is formed, the thermally oxidized film is formed on the SiO₂/Si interface by further performing the thermal oxidation treatment and, then, the annealing treatment is performed. Even still further, the final film thickness of each of Samples D, E, F and G is set to be 17 nm.

The interface state density (eV/cm²) of each of Samples D, E, F, and G obtained by the CV measurement is as shown in Table 2.

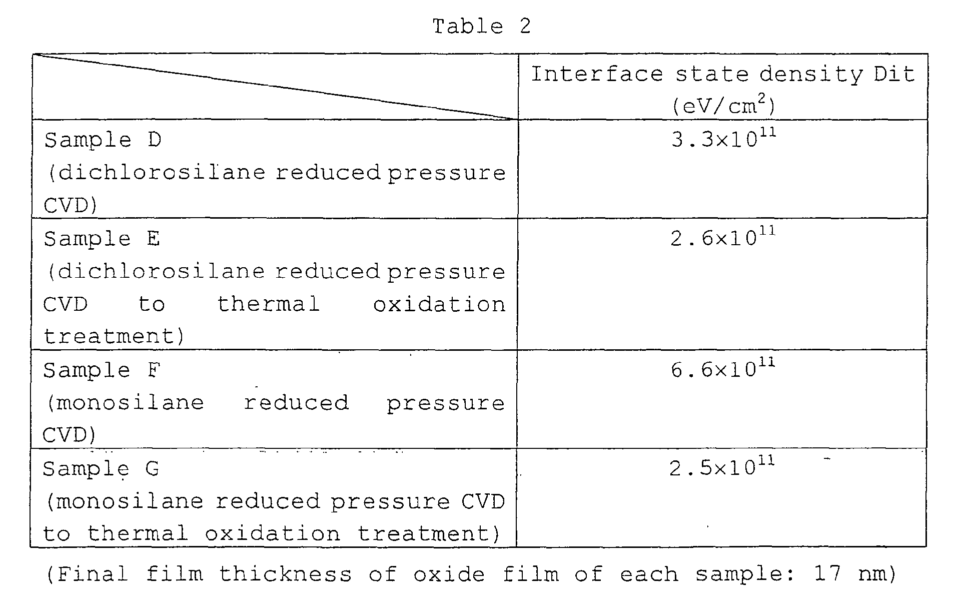

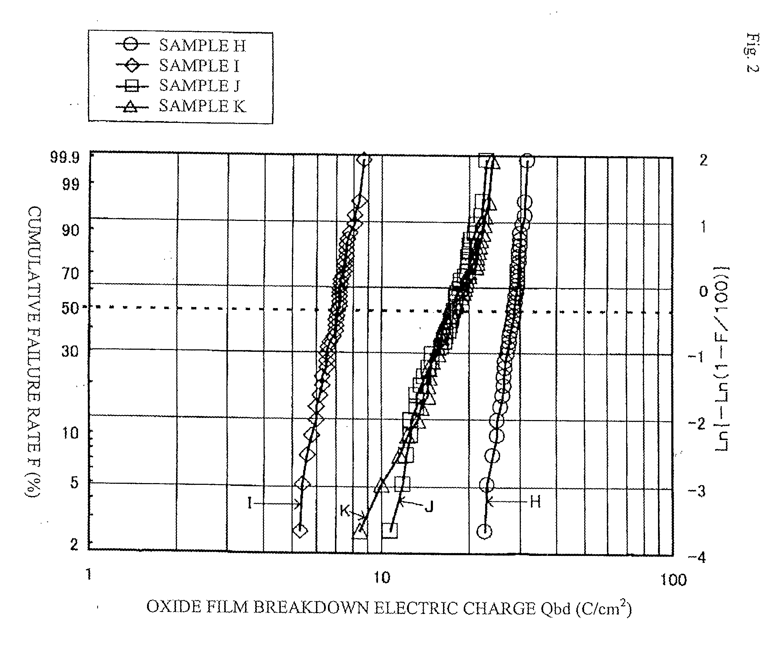

As shown in FIG. 2, the interface state density of Sample D is 3.3x10¹¹ eV/cm², while the interface state density of Sample E in which the thermally oxidized film is formed is 2.6x10¹¹ eV/cm². The interface state density is reduced by forming the thermally oxidized film on the SiO₂/Si interface after forming the HTO.

Further, the interface state density of Sample F is 6.6x10¹¹ eV/cm², while the interface state density of Sample G in which the thermally oxidized film is formed is 2.5x10¹¹ ev/cm². Reduction of the interface state density is noticed in a same manner even when monosilane is used in place of dichlorosilane in forming the HTO. The value thereof is about same as that when dichlorosilane is used.

From these findings, in a case in which the gate insulating film is formed by performing the thermal oxidation treatment after forming the HTO by the reduced pressure CVD method, any one of a dichlorosilane type gas and a monosilane type gas may be used as a raw material gas and, in each case, similarly low interface state density can be realized.

Next, an influence which the interface state density will give to the lifetime of the gate insulating film is described.
Now, on this occasion, firstly, an MOS capacitor having a planar gate structure is formed by using an Si substrate and, then, a constant current TDDB property test is performed on the planar gate sample, to thereby evaluate the lifetime of the gate insulating film.

The planar gate sample to be used on this occasion is formed in the similar order as in the above-described method of forming Sample A. On this occasion, the constant current TDDB property test is performed by using each of Sample H in which the gate insulating film is formed, on the Si substrate in which the trench is not formed, only with the thermally oxidized film by performing the thermal oxidation treatment and the annealing treatment, Sample I in which that is formed only with the HTO, Sample J in which that is formed by performing the thermal oxidation treatment and the annealing treatment after forming the HTO having a film thickness of 13 nm, and Sample K in which that is formed by performing the thermal oxidation treatment and the annealing treatment after forming the HTO having a film thickness of 10 nm. Meanwhile, the final film thickness of the gate insulating film of each of Samples H, I, J, and K is allowed to be 17 nm, and the thermally oxidized film and the HTO are formed in each of Samples H, and I, in order to attain this final film thickness, while the thermal oxidation treatment time duration after forming the HTO is adjusted in each of Samples J, and K, in order to attain this final film thickness.

FIG. 2 is an evaluation result of a constant current TDDB property of a planar gate sample.
In FIG. 2, an axis of abscissa and an axis of ordinate show oxide film breakdown electric charge Qbd (C/cm²) and cumulative failure rate F (%), respectively. Further, this constant current TDDB property test is performed using Samples H, I, J and K each having one in which 40 MOS capacitors are each formed per sheet of wafer under the conditions of a stress current density of 0.1 A/cm² and a gate negative bias. From FIG. 2, 50% Qbd of each of Samples H, I, J and K is as shown in Table 3.

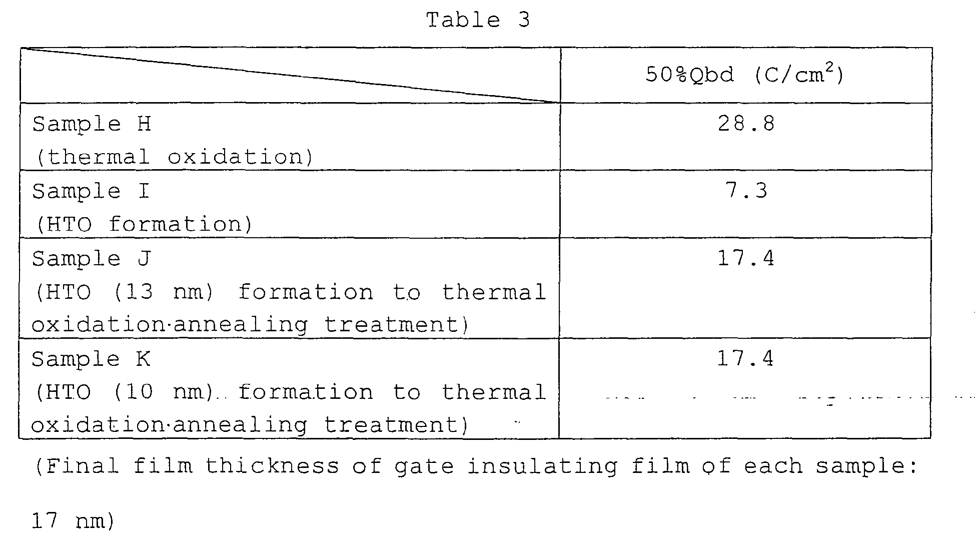

As shown in Table 3, in a case of the planar gate sample, 50% Qbd of Sample H in which the gate insulating film is formed only with the thermally oxidized film by performing the thermal oxidation treatment and the annealing treatment is the largest (28.8 C/cm²), and the lifetime of the gate insulating film thereof becomes the longest. On the other hand, 50% Qbd of Sample I in which the gate insulating film is formed only with the HTO is low (7.3 C/cm²), while Samples J and K in which the HTO is each firstly formed in a given thickness and, then, thermal oxidation is performed each have a high 50% Qbd (17.4 C/cm² in each sample) and, although 50% Qbd thereof is not so high as that of Sample H subjected to only the thermal oxidation, the lifetime of the gate insulating film thereof comes to be twice as long as or longer than that of Sample I in which only the HTO is formed.

When the thermally oxidized film is formed on an SiO₂/Si interface, the interface state density thereof is decreased and, then, not only a stable interface can be obtained, but also the lifetime of the gate insulating film can be extended to a great extent. When the above result is taken in a same manner as the above-described CV measurement result, Sample J comes to have a lower interface state density than that of Sample I by forming the thermally oxidized film and such reduction of the interface state density can contribute to a longer lifetime of the gate insulating film to a great extent.

As for the gate insulating film which is constituted by the HTO and the thermally oxidized film, when it is of planar gate structure (Samples J and K), it has a shorter lifetime than that of the gate insulating film only with the thermally oxidized film (Sample H), while, when it is of trench gate structure (Samples A and C), it has a longer lifetime than that of the gate insulating film only with the thermally oxidized film (Sample B).

From these facts, in a case of the trench gate structure, when the thermal oxidation is performed in a state in which the Si substrate is exposed, since an oxidation speed is fast, a local thinning of the thermally oxidized film due to various plane directions of the inner wall of the trench is generated. Even when the HTO is deposited thereafter, irregularity of film thickness of a first thermally oxidized film can not be compensated and, as a result, the lifetime of the gate insulating film comes to be shortened by such local thinning of the film; contrary to this, it is considered that, when the thermal oxidation is performed after the HTO is formed, since oxidizing species are diffused in the HTO and reach an interface between the HTO and the Si substrate and, then, an oxidation reaction occurs, an oxidation speed is reduced compared with the previous case, plane direction dependence of the Si substrate is suppressed, it becomes hard to generate a local thinning of the film and, then, the lifetime of the gate insulating film comes to be longer. It is supposed that this effect contributes greatly at the trench corner where thinning of the film thickness is especially marked hitherto.

Therefore, when the semiconductor device having the trench gate structure is manufactured, although depending on film thickness of the HTO, forming the thermally oxidized film on the interface between the HTO and the Si substrate after forming the HTO in the trench, rather than forming the HTO after forming the thermally oxidized film in the trench, uniformity of the film thickness comes to be favorable and the gate insulating film having a high reliability can be formed.

Next, a ratio of the HTO to the thermally oxidized film in a case in which the gate insulating film is formed by the HTO and the thermally oxidized film is described.
As shown also in Table 3, in a case of the planar gate structure, it has so far been separately confirmed that, as a volume ratio of- the HTO is smaller, the lifetime of the gate insulating film tends to be longer. On the other hand, in a case of the trench gate structure, as shown in Table 4 to be shown in below, as the film thickness of the HTO is a given value or smaller, the lifetime of the gate insulating film tends to oppositely be shorter.

**Table 4**

| HTO volume ratio (%) | HTO film thickness (nm) | 50% Qbd (C/cm²) |
|---|---|---|
| 95 | 16 | 4.23 |
| 76 | 13 | 4.54 |
| 59 | 10 | 1.43 |
| 41 | 7 | 0.65 |
| 0 | 0 | 0.48 |

| | | |
|---|---|---|
| (Final film thickness of gate insulating film: 17 nm) | | |

As shown in FIG. 4, in a case in which the final film thickness of the gate insulating film containing the HTO and the thermally oxidized film is 17 nm, when the HTO has a film thickness of 13 nm (volume ratio: 76%), 50% Qbd comes to be the highest (4.54 C/cm²) and, when it has a film thickness of 16 nm (volume ratio: 95%), 50% Qbd comes to be reduced to some extent (4.23 C/cm²). Contrarily, when the film thickness comes to be smaller (volume ratio is reduced) in the order of 10 nm (volume ratio: 59%), 7 nm (volume ratio: 41%), and 0 nm (volume ratio: 0%), 50% Qbd thereof similarly comes to be smaller (1.43 C/cm², 0.65 C/cm², and 0.48 C/cm², respectively).

It is considered that such difference as described above is derived from a local thinning of the film thickness. Namely, when the final film thickness of the gate insulating film is set to be 17 nm, as the film thickness of the HTO to be formed prior to the thermally oxidized film comes to be smaller, the film thickness ratio of the thermally oxidized film to be formed thereafter comes to be larger by that much. On this occasion, the oxidation speed is affected with an influence of the plane direction dependence of the Si substrate stronger than before and, then, locally, particularly, at a trench corner, thinning of the film thickness tends to occur. As a result of such thinning of the film thickness, concentration of electric field on such portion as described above tends to occur when the device is operated and, then, the lifetime of the gate insulating film tends to be shortened.

As seen from FIG. 4, when the final film thickness of the gate insulating film is set to be 17 nm, it is desirable that the HTO is formed such that it has a film thickness of 10 nm (volume ratio: 59%) or more. By this, the lifetime of the gate insulating film can be extended to be three times as long as or longer than that of the gate insulating film formed only by thermal oxidation. Further, when the gate insulating film is formed only with the HTO, since it is given an influence of such interface state density as described above to a great extent (refer to Tables 2 and 3), it is preferable to form the HTO with a film thickness which has such a volume ratio as to slightly thermally oxidize the interface.

Further, herein, the case in which the final film thickness of the gate insulating film is set to be 17 nm has so far been described; however, even when it is applied to the semiconductor device with a trench gate structure containing the gate insulating film having a different final film thickness from this, similar effect can be obtained within the range of the same volume ratio. Practically, taking controllability of the film thickness by thermal oxidation into consideration, it is preferably to set the volume ratio of the HTO to be formed prior to the thermally oxidized film to be within the range of from about 50% to about 95% of the gate insulating film to be finally formed.

Next, the thermal oxidation treatment and the annealing treatment are described.
When the HTO is formed by using a raw material gas including dichlorosilane, it is known that chlorine and hydrogen remain in the film as they are. Chlorine or hydrogen remaining in the HTO acts as an electron trap in the oxide film and becomes to a factor for shortening the lifetime of the gate insulating film. Then, a chlorine concentration and hydrogen concentration in the HTO after the above-described thermal oxidation treatment was performed at about 800°C and the annealing treatment was performed for about 10 minutes at about 1000°C in nitrogen were examined by using a Secondary Ion Mass Spectroscopy (SIMS).

As a result, the chlorine concentration was 2x10²¹/cm³ immediately after the formation of the HTO and, after the thermal oxidation treatment, it fell below measurable limits; therefore, it has been found that most of chlorine in the HTO was able to be removed therefrom by the thermal oxidation treatment. Further, the hydrogen concentration in the HTO was 2x10²¹/cm³ immediately after the formation of the HTO and, after the thermal oxidation treatment, it was reduced to be 3x10²⁰/cm³. Further, after the annealing treatment, it fell below measurable limits; therefore, it has been found that most of hydrogen in the HTO was able to be removed therefrom.

By performing such thermal oxidation treatment and annealing treatment as described above, firstly chlorine is mostly removed by the thermal oxidation treatment and, then, hydrogen is mostly removed by the subsequent annealing treatment from the HTO, to thereby mostly eliminate the electron trap in the HTO. By these procedures, a highly reliable gate insulating film can be formed and improvement of the electric property of the device can be realized.

Further, in a production process of the semiconductor device having the trench gate structure, it is not always necessary to perform the annealing treatment and it is possible to perform only the thermal oxidation treatment after formation of the HTO and form the gate insulating film. By this procedure, it is possible to obtain a given elimination effect of the electron trap. Further, so long as the annealing temperature is about 1000°C, a sufficient effect can be obtained and, so long as it is about 850°C or more, a similar effect can be obtained in reducing the hydrogen concentration in the film.

Next, a result obtained by examining more carefully conditions of forming the gate insulating film is described.
It is preferable that the thermal oxidation at the time of forming the gate insulating film is performed by using a pyrogenic oxidation method which utilizes a thermal reaction (pyrogenic reaction) between hydrogen and oxygen in the raw material in such a manner as described above. On this occasion, a result of examination on the influence which conditions of the pyrogenic oxidation give to reliability of the gate insulating film is described.

Firstly, a method for forming an MOS capacitor having the trench gate structure for use in evaluation of reliability of the gate insulating film is described.
As for the MOS capacitor, firstly, a trench in which a bottom portion was in a round shape was formed in an Si substrate by etching. In order to remove etching damage remaining in the Si substrate (on a surface of the trench), a sacrificial oxidation was performed. On this occasion, the trench was allowed to have a width of 0.6 µm and a depth of 2 µm and film thickness of a sacrificial oxidation film was allowed to be in the range of from 50 nm to 150 nm.

Next, in order to form the gate insulating film, firstly, the HTO was formed such that it had a film thickness of 80 nm using dichlorosilane and dinitrogen monoxide as raw material gases by the reduced pressure CVD method. At that time, as for the forming conditions, on this occasion, gas flow rates of dichlorosilane and dinitrogen monoxide were set to be 200 sccm and 66 sccm, respectively, a film-forming temperature was set to be about 800°C and a pressure was set to be 60 Pa. Next, pyrogenic oxidation (diluted pyrogenic oxidation) was performed in a thermal treatment furnace at an appropriate oxidation temperature, on this occasion, about 1000°C using a reaction gas which was diluted with an inert gas and, then, the gate insulating film having a final film thickness of 100 nm was formed.

By such diluted pyrogenic oxidation as described above, oxygen is diffused in the HTO which has previously been formed and is supplied to a surface of the Si substrate, to thereby form the thermally oxidized film on an interface between the HTO and the Si substrate. Further, in the diluted pyrogenic oxidation of high temperature (high-temperature diluted pyrogenic oxidation) in which the oxidation temperature to be applied on this occasion is about 1000°C, stress present in the trench portion comes to be relaxed by a viscous flow of each of the HTO which has been formed and the thermally oxidized film to be formed.

At the time of the diluted pyrogenic oxidation, nitrogen is used for a dilution gas. A dilution ratio thereof is set such that water partial pressure to be generated in an atmosphere of pyrogenic oxidation comes to have a ratio (water partial pressure ratio) in the range, based on the entire gas in a chamber, of from 0.03 to 0.10. Further, an oxidation time duration is adjusted such that the final film thickness after the thermal oxidation treatment comes to be 100 nm. By diluting the reaction gas with the inert gas in such manner as described above, control of the film thickness of the thermally oxidized film is facilitated. Such dilution is effective in forming the thermally oxidized film particularly having a small thickness.

For example, when the HTO having a film thickness of 80 nm is formed by using dichlorosilane and dinitrogen monoxide as described above is formed, by performing the high-temperature diluted pyrogenic oxidation for 15 minutes at a temperature of about 1000°C with a water partial pressure ratio of 0.09, the gate insulating film having a final film thickness of 100 nm can be obtained. Further, when the HTO having a film thickness of 90 nm is firstly formed, by performing the high-temperature diluted pyrogenic oxidation for 15 minutes at a temperature of about 1000°C with a water partial pressure ratio of 0.03, the gate insulating film having a final film thickness of 100 nm can be obtained.

Further, on this occasion, a case in which the oxidation temperature of the high-temperature diluted pyrogenic oxidation was set to be about 1000°C is illustrated; however, so long as the temperature is about 950°C or more in an atmosphere containing water, the viscous flow of the oxide film occurs. When the oxidation temperature is set to be about 950°C, in a case in which the film thickness of the HTO which has previously formed remains same, for example, a water partial pressure ratio is allowed to be increased to some extent. Further, in this case, since an oxidation speed is decreased in accordance with lowering of the oxidation temperature, for example, the oxidation time duration is adjusted such that it comes to be 15 minutes or more.

After the thermal oxidation treatment, by continuously using the same thermal treatment furnace, temperature was raised up to about 1000°C in an atmosphere of nitrogen and an annealing treatment was performed at this temperature for 10 minutes.
Finally, polysilicon which became a gate electrode was formed by a reduced pressure CVD method and, then, the gate electrode was formed by a photolithography technique. Thereafter, for example, an interlayer insulating film was formed and, further, even an Al wiring was formed, to thereby form the MOS capacitor (Sample M). A gate area of the MOS capacitor of Sample M was about 20 mm².

Further, for the purpose of comparison with Sample M, Sample N in which the gate insulating film having a final film thickness of 100 nm was formed in the trench in the Si substrate without dilution at a temperature of about 1000°C by pyrogenic oxidation (high-temperature pyrogenic oxidation) and subjected to the annealing treatment at a temperature of about 1000°C in an atmosphere of nitrogen, Sample O in which the HTO having a film thickness of 80 nm was formed in the trench by the reduced pressure CVD method and, then, the gate insulating film having a final film thickness of 100 nm was formed by performing the pyrogenic oxidation without dilution at a temperature as low as about 800°C (low-temperature pyrogenic oxidation) and subjected to the annealing treatment at a temperature of about 1000°C in an atmosphere of nitrogen, and Sample P in which the HTO having a film thickness of 100 nm was formed in the trench by the reduced pressure CVD method were simultaneously formed. Further, other constitutional factors, film-forming conditions and the like than the gate insulating film are same all through Samples M, N, O, and P.

80 MOS capacitors are prepared for each of these Samples M, N, O, and P and were subjected to a Time Zero Dielectric Breakdown (TZDB) property test under a condition of a gate negative bias. Further, on this occasion, breakage voltage is denoted in a negative value and it is shown that, as the absolute value thereof is larger, namely, as the value in negative is larger, the breakdown voltage is larger. An average breakdown voltage (V) of 80 MOS capacitors of each of Samples M, N, O and P, and a ratio (%) of MOS capacitors having a breakdown voltage of -60V or less of each of Samples M, N, O and P which are obtained as a result of the TZDB property test are shown in Table 5.

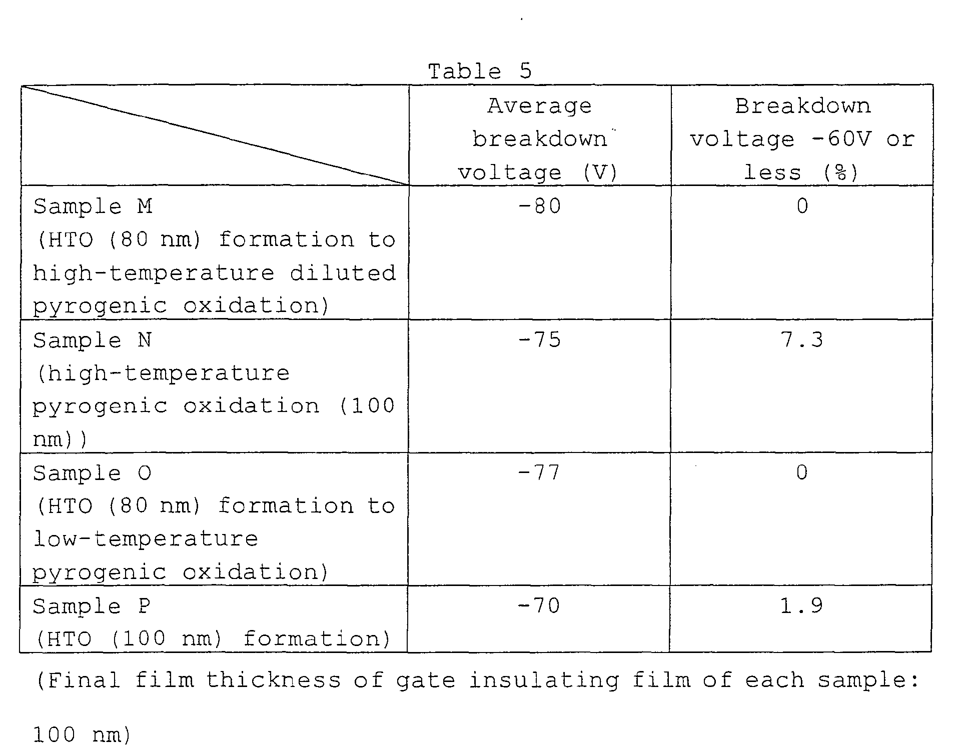

From Table 5, firstly, as for the average breakdown voltage, that of Sample M in which the HTO having a film thickness of 80 nm is formed in the trench by using the reduced pressure CVD method and, then, subjected to the high-temperature diluted pyrogenic oxidation at a temperature of about 1000°C and, accordingly, the gate insulating film having a final film thickness of 100 nm is formed is the highest as being -80V. Then, the average breakdown voltages of Sample O, Sample N, and Sample P, which are decreased in the stated order, are -77V, -75V, and -70V, respectively.

As for the reason why the average breakdown voltage is the highest in Sample M, it is mentioned that, firstly, in Sample M, the gate insulating film is formed by forming the thermally oxidized film while allowing a viscous flow of each of the HTO and the thermally oxidized film to be performed by the high-temperature diluted pyrogenic oxidation. The stress in the trench portion is relaxed by the high-temperature diluted pyrogenic oxidation and, then, a local thinning of the film thickness in an upper portion or a bottom portion of the trench portion is avoided and, then, the gate insulating film is formed on an inner wall of the trench with a good uniformity and, as a result, a high average breakdown voltage can be obtained. In Sample M, a high average breakdown voltage can be obtained even compared with Sample O in which, after the HTO was formed, the gate insulating film is formed by performing the low-temperature pyrogenic oxidation at a temperature of about 800°C and it can be mentioned that the viscous flow to be generated by a high-temperature dilution condition contributes to improvement of the breakdown voltage.

Then, secondly, it can be mentioned that, although the interface state density on the SiO₂/Si interface is high only with formation of the HTO on an inner wall of the trench as shown in Table 2 and 3, the interface state density can be suppressed low by forming the thermally oxidized film on an interface between the HTO and the Si substrate by performing the high-temperature diluted pyrogenic oxidation. In Sample P in which the gate insulating film is formed only with the HTO, the average breakdown voltage thereof is inferior even to that of Sample N in which the gate insulating film is formed by performing the high-temperature pyrogenic oxidation at a temperature of about 1000°C and, then, the annealing treatment is performed at a temperature of about 1000°C in an atmosphere of nitrogen.

Further, the fact that the average breakdown voltage of each of Samples M and O is higher than that of Sample N shows, as shown in FIGS. 1 and 2, and Tables 1 and 3, that, after the HTO is formed, the gate insulating film is formed by performing the pyrogenic oxidation.

Further, as shown in FIG. 5, the MOS capacitor in which the breakdown voltage is -60 V or less appears only in Sample N in which the gate insulating film is formed only with the pyrogenic oxidation and Sample P in which the gate insulating film is formed only with the HTO. In each of Samples M and O in which, after the HTO is formed, the pyrogenic oxidation is performed, it appears at 0%.

In Sample N, a remaining stress originated in a volume expansion of an inner wall of the trench by the pyrogenic oxidation is a main factor for causing the low breakdown voltage and, in Sample P, a low interface state density of the SiO₂/Si interface is a main factor for causing the low breakdown voltage. To contrast, in Samples M and O, about 80 percent of the gate insulating film is constituted with the HTO and remaining 20 percent thereof is constituted with the thermally oxidized film by the pyrogenic oxidation and, then, even when etching damage or crystal defect is present in the trench portion, an influence thereof to the gate insulating film to be finally obtained will be suppressed by forming the thermally oxidized film between the inner wall of the trench and the HTO.

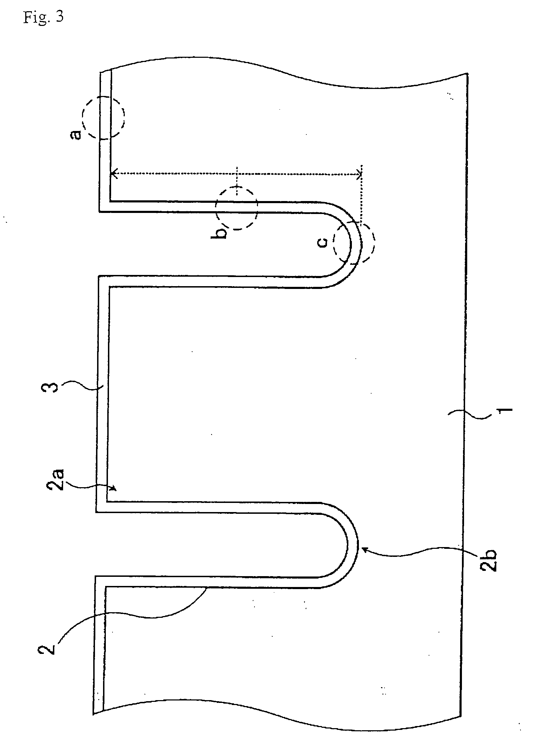

FIG. 3 is a schematic cross-sectional diagram of a gate insulating film.
As described above, in Samples M and O, by performing the pyrogenic oxidation after the HTO is formed, the thermally oxidized film is formed while volume expansion of the Si substrate 1 is suppressed by the HTO and, on the inner wall of the trench 2 formed in the Si substrate 1, particularly in the upper portion 2a or the bottom portion 2b of the trench 2, the gate insulating film 3 with a film thickness of good uniformity comes to be formed. Particularly in Sample M, by performing the high-temperature diluted pyrogenic oxidation after the HTO is formed in the manner as described above, the gate insulating film 3 with a high reliability can be formed. Further, in Sample O, although a given reliability can be obtained, since formation of the thermally oxidized film is not performed under a high-temperature dilution condition, a viscous flow hardly occurs and, then, the breakdown voltage thereof is decreased to some extent compared with Sample M.

Subsequently, result of examination of forming conditions of the gate insulating film by using a sample in which a trench width is decreased.
In the above-described Samples M, N, O, and P, the trench width thereof was set to be 0.6 µm, but, on this occasion, samples which each has a trench width of 0.4 µm was formed and, then, similarly as in the above, the TZDB property test was performed and the average breakdown voltage and the like were evaluated.

Firstly, samples for use in evaluations were formed under same conditions as in Samples M, N, O, and P described above except that the trench width was set to be 0.4 µm. Namely, on this occasion, Sample Q in which the bottom portion of the trench was formed in a round shape, the HTO having a film thickness of 80 nm was formed in the trench by using the reduced pressure CVD method, a high-temperature diluted pyrogenic oxidation was performed thereon at a temperature of about 1000°C to form the gate insulating film having a final film thickness of 100 nm and, thereafter, the annealing treatment was performed thereon at a temperature of about 1000°C in an atmosphere of nitrogen, Sample R in which the gate insulating film having a final film thickness of 100 nm was formed in the trench in the Si substrate at a temperature of about 1000°C by using the high-temperature pyrogenic oxidation without dilution and, then, the annealing treatment was performed thereon at a temperature of 1000°C in an atmosphere of nitrogen, Sample S in which the HTO having a film thickness of 80 nm was formed in the trench by using the reduced pressure CVD method, a low-temperature pyrogenic oxidation without dilution was performed thereon at a temperature of about 800°C to form the gate insulating film having a final film thickness of 100 nm and, thereafter, the annealing treatment was performed thereon at a temperature of about 1000°C in an atmosphere of nitrogen, and Sample T in which the HTO having a film thickness of 100 nm was formed in the trench by using the reduced pressure CVD method were used. Further, other constitutional factors, film-forming conditions and the like than the gate insulating film are same all through Samples Q, R, S, and T.

80 MOS capacitors are prepared for each of these Samples Q, R, S, and T and were subjected to the TZDB property test under a condition of a gate negative bias. An average breakdown voltage (V) of 80 MOS capacitors of each of Samples Q, R, S, and T, and a ratio (%) of MOS capacitors having a breakdown voltage of -60V or less of each of Samples Q, R, S, and T are shown in Table 6.

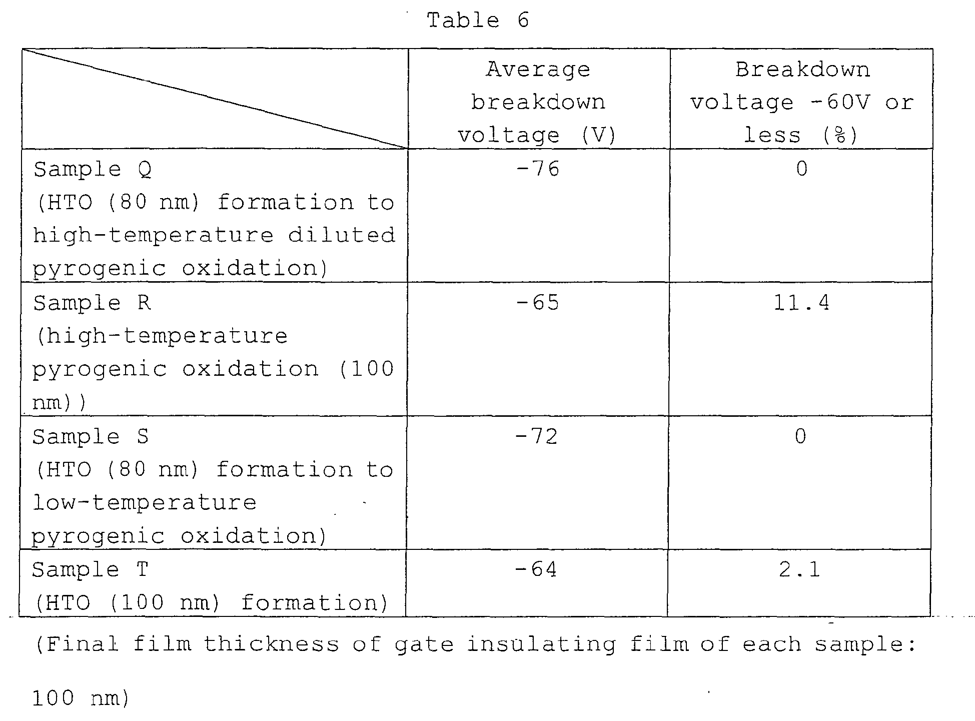

Ordinarily, when the trench width is decreased as being from 0.6 µm to 0.4 µm, the stress generated in the trench portion at the time of oxidation is hardly relaxed only with ordinary thermal oxidation and a local thinning of the film thickness of the gate insulating film comes to easily occur and, then, such thinning of the film thickness may cause reduction of the breakdown voltage.

From Table 6, in each of Sample Q and Sample S in which the gate insulating film is formed by performing pyrogenic oxidation after the HTO is formed, the average breakdown voltage is high compared with Sample R in which the gate insulating film is formed only by performing the pyrogenic oxidation or Sample T in which the gate insulating film is formed only with the HTO, and does not generate the MOS capacitor in which the breakdown voltage is -60 V or less. Particularly, in Sample Q in which the high-temperature diluted pyrogenic oxidation is performed, the average breakdown voltage comes to be higher practically by 10 V or more compared with Samples R and T, the gate insulating film is formed on an inner wall of the trench with a film thickness of good uniformity and, further, the interface state density can be suppressed low by forming the thermally oxidized film between the HTO and the Si substrate.

Still further, ordinarily, when the gate insulating film is formed by forming the thermally oxidized film after the HTO is formed, as described above, when the film thickness ratio of the thermally oxidized film is larger, the oxidation speed tends to be influenced more strongly by a plane direction dependency of the Si substrate and, therefore, it is preferable that the film thickness of the thermally oxidized film to be formed is smaller. However, when the HTO comes to be thicker, it is necessary to pay attention to difficulty of controlling the film thickness of the thermally oxidized film to be formed thereafter. According to a method in which, as described above, the gate insulating film is formed by performing the pyrogenic oxidation after the HTO is formed, the volume ratio of the HTO in the gate insulating film is allowed to be higher and, further, under a pyrogenic atmosphere, particularly, under a high-temperature diluted pyrogenic atmosphere, the thermally oxidized film is formed and, then, the influence of the stress in the trench portion can be suppressed. By these arrangements, the gate insulating film having a film thickness of good uniformity can be formed in the trench and, then, the semiconductor device of high breakdown voltage and high reliability can be realized.

Subsequently, a result of examination on raw materials at the time of forming the HTO is described.
Formation of the HTO at the time of forming the gate insulating film was performed by the reduced pressure CVD method using dichlorosilane or monosilane and dinitrogen monoxide as raw material gases as described above. On this occasion, a result of examination on reliability of the gate insulating film in a case in which, particularly, dichlorosilane is used as a raw material gas is described.

Firstly, a method for forming the MOS capacitor having a trench gate structure used for evaluation of reliability of the gate insulating film is described.
As for the MOS capacitor, firstly, the trench having a bottom portion in a round shape is formed in the Si substrate by etching and, in order to remove an etching damage remaining on the Si substrate (trench surface), the inner wall of the trench was etched by isotropic dry etching by a thickness of 50 nm or 100 nm. Thereafter, sacrificial oxidation was performed. On this occasion, the trench, before being subjected to isotropic dry etching, was allowed to have a width of 0.6 µm and a depth of 2 µm and the sacrificial oxide film was allowed to be 100 nm. Further, on this occasion, a sample which was not subjected to the isotropic dry etching was also prepared.

In each of these three samples in which isotropic dry etching amounts are different from one another, under same conditions as in the forming conditions of Sample M, the HTO having a film thickness of 80 nm was formed using dichlorosilane and dinitrogen monoxide as raw material gases by the reduced pressure CVD method and, then, the thermally oxidized film was formed by the high-temperature diluted pyrogenic oxidation and, thereafter, the gate insulating film having a final film thickness of 100 nm was formed. Then, the annealing treatment was performed thereon for 10 minutes at about 1000°C in an atmosphere of nitrogen and, thereafter, the gate electrode, the interlayer insulating film and the A1 wiring were formed, to thereby form the MOS capacitor. The gate area was about 20 mm² regardless of isotropic dry etching amounts.

On this occasion, samples in which the isotropic dry etching amounts are 0 nm, 50 nm, and 100 nm are denoted as Sample U1, Sample U2, and Sample U3, respectively.

Further, for the purpose of comparison with Samples U1, U2, and U3, Samples W1, W2, and W3 in which the isotropic dry etching amounts after trench etching are allowed to be 0 nm, 50 nm, and 100 nm, respectively, and gates insulating films were formed each having a final film thickness of 100 nm in each trench in each Si substrate by high-temperature pyrogenic oxidation without dilution at a temperature of about 1000°C and, then, the annealing treatment was performed thereon at about 1000°C in an atmosphere of nitrogen were simultaneously be formed. Further, other constitutional factors, film-forming conditions and the like than the gate insulating film of Samples W1, W2, and W3 are same with those of Samples U1, U2, and U3, respectively.

80 MOS capacitors were prepared for each of these Samples U1, U2, U3, W1, W2, and W3 and were each subjected to a cross-sectional observation by using a transmission electron microscope and the TZDB property test under a condition of the gate negative bias.

The results obtained by measuring a film thickness of an oxide film of each of Samples U1, U2, U3, W1, W2, and W3 by the transmission electron microscope are shown in Table 7. Further, the term "trench outer surface oxide film thickness" as used in Table 7 indicates a film thickness of an oxide film formed on the surface of the substrate other than the trench, namely, "a" portion shown in FIG. 3. Further, the term "trench inner wall oxide film thickness" as used in Table 7 indicates a film thickness of an oxide film formed on the position at half the depth of the trench, namely, "b" portion shown in FIG. 3. Still further, the term "trench bottom portion oxide film thickness" as used in Table 7 indicates a film thickness of an oxide film formed on the bottom portion of the trench, namely, "c" portion shown in FIG. 3.

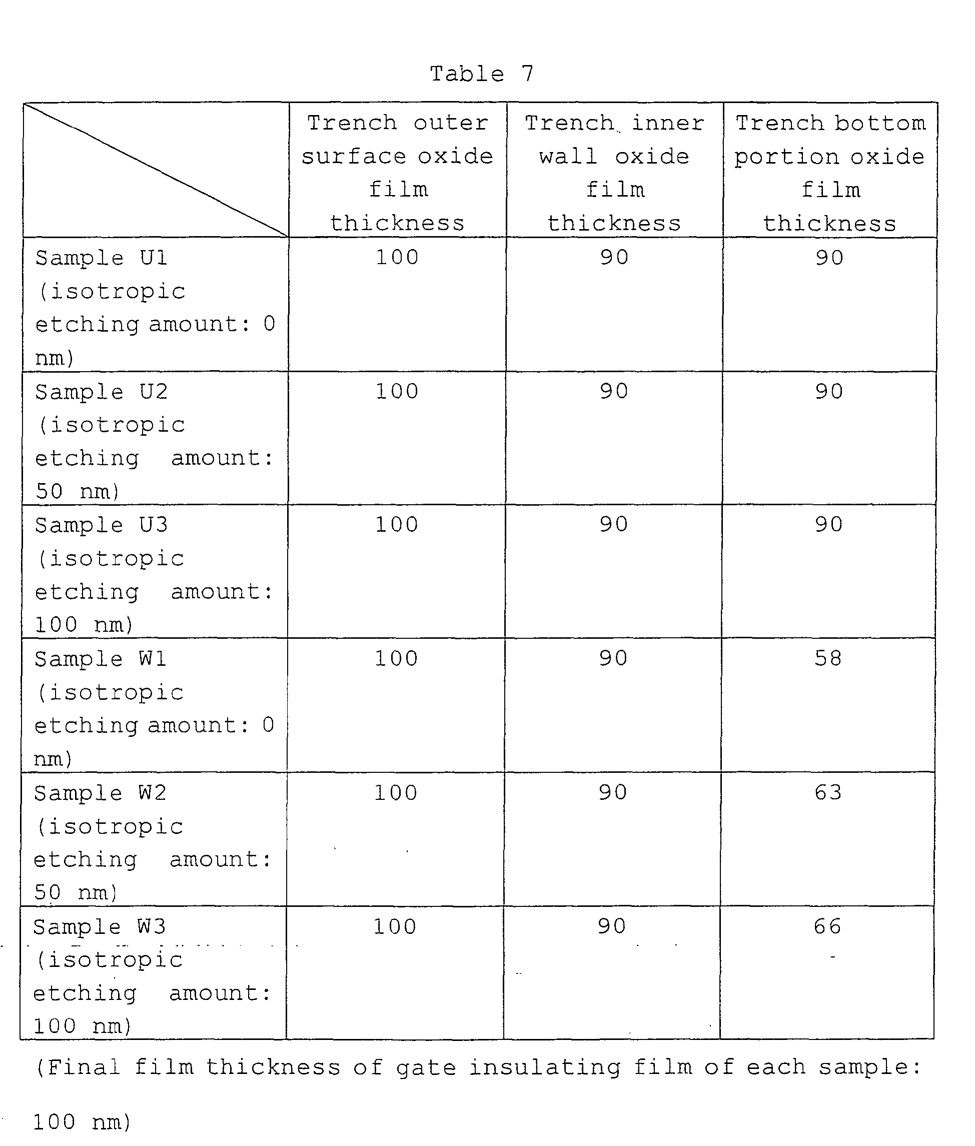

From Table 7, step coverage of each of Samples U1, U2 and U3 is 0.9, whereas that of each of Samples W1, W2, and W3 is about 0.6. By this fact, it was confirmed that, by forming the gate insulating film by performing the high-temperature diluted pyrogenic oxidation after forming the HTO, the gate insulating film having a good coverage can be formed in the trench.

Further, An average breakdown voltage (V) of 80 MOS capacitors of each of Samples U1, U2, U3, W1, W2, and W3, and a ratio (%) of MOS capacitors having a breakdown voltage of -60V or less of each of Samples U1, U2, U3, W1, W2, and W3 which are obtained as a result of the TZDB property test are shown in Table 8.

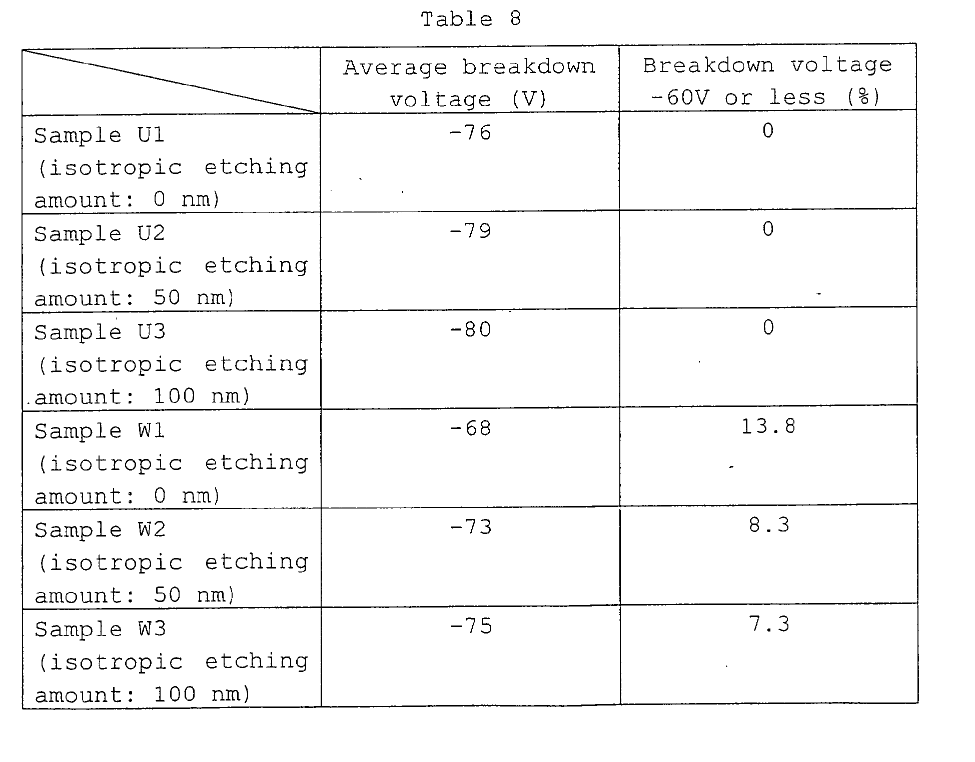

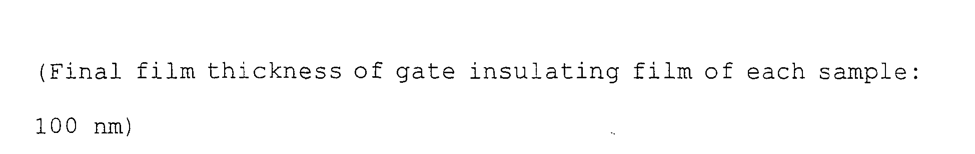

From Table 8, firstly, as for the average breakdown voltage, in a case in which the isotropic dry etching amount is same, the average breakdown voltage in each of Samples U1, U2, and U3 is larger than that in each of Samples W1, W2, and W3 to a great extent. As is described above, this is because there is an effect of forming the thermally oxidized film by the high-temperature diluted pyrogenic oxidation after forming the HTO in Samples U1, U2, and U3.

Further, from Table 8, in Samples U1, U2, and U3, and Samples W1, W2, and W3, when the isotropic dry etching amount is increased, the average breakdown voltage is increased. This is because, by dry-etching mainly the inner wall of the trench, the curvature of the bottom portion of the trench comes to be larger and, then, the concentration of the electric field hardly occurs.

Further, even though Sample U1 does not perform the isotropic dry etching, it shows higher average breakdown voltage than that of Sample W3 which performs the isotropic dry etching by a thickness of 100 nm. In other words, when the gate insulating film is formed only with the pyrogenic oxidation, only by performing the isotropic dry etching of a thickness of 100 nm as in Sample W3, the breakdown voltage can be lifted up to a level similar to that of Sample U1 in which the HTO is formed without performing the isotropic dry etching and, thereafter, the high-temperature diluted pyrogenic oxidation is performed. Further, from this fact, even when the isotropic dry etching amount is small, namely, the curvature of the bottom portion of the trench is small, by performing the high-temperature diluted pyrogenic oxidation after forming the HTO, the gate insulating film having a film thickness of good uniformity can be formed.

Further, the ratio of MOS capacitors in which the breakdown voltage is -60 V or less is 0% in any one of Samples U1, U2, and U3. In contrast, in Samples W1, W2, and W3, as the isotropic dry etching amount is decreased, the ratio is increased. As one of reasons for it, firstly, it can be mentioned that, in Samples U1, U2, and U3, by performing the high-temperature diluted pyrogenic oxidation after forming the HTO, the gate insulating film having a film thickness of good uniformity is formed.

Secondly, it can be mentioned that chlorine contained in dichlorosilane which is a raw material gas at the time of forming the HTO plays a role of gettering a heavy metal such as iron, aluminum or nickel out of the Si substrate during the CVD reaction, even when such heavy metal is infiltrated into the Si substrate at the time of trench etching.

The heavy metal infiltrated in the Si substrate can be removed by performing the isotropic dry etching and, as is found from the result obtained about Samples W1, W2, and W3 in Table 8, as the isotropic dry etching amount is increased, the ratio of MOS capacitors in which the breakdown voltage is -60 V or less is decreased. However, in Samples W1, W2, and W3 in which the HTO is not formed using dichlorosilane, even in Samples W2, and W3 in which the isotropic dry etching is performed, the heavy metal can not fully be removed. In Samples U1, U2, and U3, by forming the HTO using dichlorosilane, regardless of performing or not performing the isotropic dry etching, the heavy metal can be removed.

Further, even when chlorine contained in dichlorosilane remains in the gate insulating film, as described above, it can be removed in a later step, namely, the annealing treatment.
In such manner as described above, when the gate insulating film is formed, the HTO is formed using dichlorosilane as a raw material and, then, by performing the high-temperature diluted pyrogenic oxidation, the gate insulating film having a film thickness of good uni formity can be formed in the trench and, further, contamination with the heavy metal can be suppressed. By these procedures, the semiconductor device having a high breakdown voltage and a high reliability can be realized. As described above, although it is possible to form the gate insulating film of high reliability even using monosilane as a raw material, when the width of the trench is decreased, dichlorosilane is better as the raw material from the standpoint of removing the heavy metal.

Still further, a method in which, after the trench etching, the HTO is formed using dichlorosilane is not limited to a case in which, as described above, the gate insulating film is formed by performing the thermal oxidation after forming the HTO and is applicable to a case in which the gate insulating film is formed only with the HTO. In doing so, even when the heavy metal is infiltrated in the semiconductor substrate at the time of trench etching, it is possible to remove it and, accordingly, an improvement of reliability of the gate insulating film to a given extent can be aimed for.

As has been described above, according to the method for producing the semiconductor device of the invention, not only the local thinning of the film thickness of the gate insulating film in the trench can be suppressed, but also the interface state density can be decreased by changing the SiO₂/Si interface into the thermally oxidized interface. Further, by this thermal oxidation treatment and the accompanying annealing treatment, an element such as chlorine or hydrogen which will be an electron trap in the gate insulating film can be removed.

Even still further, by forming the thermally oxidized film by performing the pyrogenic oxidation, particularly the high-temperature diluted pyrogenic oxidation, the improvement of the reliability of the gate insulating film can be aimed for. Moreover, by forming the HTO before forming such thermally oxidized film as described above by performing the reduced pressure CVD method using dichlorosilane as the raw material gas, even when the heavy metal is infiltrated in the semiconductor substrate at the time of trench etching, it is possible to remove it and aim for a further improvement of the reliability of the gate insulating film.

When thus-formed gate insulating film is applied to various types of semiconductor devices each having the trench gate structure inclusive of the TLPM, electric properties such as the breakdown voltage are improved and, then, the highly reliable semiconductor device can be produced. Further, it can be applicable also to the semiconductor device having the planar gate structure.

The principle of the invention has only been described above. Many alterations, modifications and changes can be made by those who are skilled in the art and the invention is not limited to those precise constitutions and applications as have been indicated and described above and all the alterations and equivalents corresponding thereto are to be construed as being within the scope and spirit of the invention as defined in the appended claims and equivalents thereof.

### Description of Reference Numerals and Signs

- 1: Si substrate
- 2: trench
- 2a: upper portion
- 2b: bottom portion
- 3: gate insulating film
- 100, 300: MISFET
- 101, 201: p⁻type semiconductor substrate
- 102, 204: p type base region
- 103: n⁺type drain region
- 104: p⁺type source region
- 105, 209: n⁺type source region
- 106, 208, 309: source electrode
- 107, 211: drain electrode
- 108, 205, 306: gate insulating film
- 109, 206, 307: gate electrode
- 110: n⁻type extended drain
- 200: TLPM
- 202, 305, 401: trench
- 203: n type extended drain
- 207: first insulating film
- 210: second insulating film
- 301, 400: semiconductor substrate
- 302: electric field relaxation region
- 303: base region
- 304: source region
- 308: interlayer insulating film
- 402: thermally oxidized film

## Claims

1. A method for producing a semiconductor device, which has a trench gate structure, being **characterized by** comprising the steps of:
forming an oxide film by a Chemical Vapor Deposition method on an inner wall of a trench formed in a semiconductor substrate;
forming a thermally oxidized film on an interface between the oxide film and the semiconductor substrate by a thermal oxidation method; and
forming a gate insulating film comprising the oxide film and the thermally oxidized film in the trench.

2. The method for producing the semiconductor device according to Claim 1, being **characterized in that** the oxide film is formed by a reduced pressure CVD method.

3. The method for producing the semiconductor device according to Claim 1, being **characterized in that** the oxide film is formed by using a gas comprising dichlorosilane and dinitrogen monoxide as a raw material.

4. The method for producing the semiconductor device according to Claim 1, being **characterized in that** the oxide film is formed by using a gas comprising monosilane and dinitrogen monoxide as a raw material.

5. The method for producing the semiconductor device according to Claim 1, being **characterized in that** the oxide film is formed such that it has a film thickness of from about 50% to about 90% of that of the gate insulating film to be finally formed.

6. The method for producing the semiconductor device according to Claim 1, being **characterized in that** the thermally oxidized film is formed on an interface between the oxide film and the semiconductor substrate by a pyrogenic oxidation method.

7. The method for producing the semiconductor device according to Claim 1, being **characterized in that** the thermally oxidized film is formed on an interface between the oxide film and the semiconductor substrate by a high-temperature-dilution pyrogenic oxidation method which is performed by diluting a reaction gas with an inert gas and is performed with high temperature.

8. The method for producing the semiconductor device according to Claim 7, being **characterized in that** the high-temperature-dilution pyrogenic oxidation method is performed at a temperature of about 950°C or more.

9. The method for producing the semiconductor device according to Claim 1, being **characterized by** comprising the steps of:
forming the gate insulating film; and
performing an annealing treatment in an atmosphere of nitrogen.

10. The method for producing the semiconductor device according to Claim 9, being **characterized in that** the annealing treatment is performed at a temperature of from about 850°C to about 1000°C.

11. A method for producing a semiconductor device, which has a trench gate structure, being **characterized by** comprising the step of:
forming an oxide film on an inner wall of a trench formed in a semiconductor substrate by a Chemical Vapor Deposition method using a gas comprising dichlorosilane and dinitrogen monoxide as a raw material.
